# EUROPEAN PATENT APPLICATION

(11) **EP 1 593 450 A1**
(43) Date of publication of application: **09.11.2005**
(21) Application number: 05252728.0
(22) Date of filing: 03.05.2005
(51) Int. Cl.: B23K 1/00, H05K 3/34, H05K 3/26

(54) **Electronic device with surface mount components having stand-off space free of solder mask under the component - method for manfacturing the same**

(30) Priority: 04.05.2004 US 838897
(71) Applicant: Agere System Inc., Allentown, PA 18109 (US)
(72) Inventor: Albanese, Patricia Marie, Conshohocken, PA 19428 (US); Osenbach, John W., Kutztown, PA 19530 (US); Shilling, Thomas H., Macungle, PA 18062 (US)
(74) Representative: Williams, David John

(57) **Abstract**

The specification describes a surface mount method for the manufacture of high device density circuit boards. The stand-off space of the components (11) on the board (13) can be enlarged significantly by selectively omitting, or selectively removing, the soldermask (16) underneath the component (11) package. This improves access of the cleaning fluid to the underside of the component (11) during the cleaning operation.

## Description

### Field of the Invention

This invention relates to surface mount technology (SMT) and to methods for mounting SMT components that promote improved post-solder cleaning.

### Background of the Invention

Approaches to the manufacture of printed circuit boards (PCBs) for electronic equipment has undergone many changes as component size shrinks and component density on the supporting board increases. The familiar dual-in-line package (DIP), with through-hole leads, has been largely replaced by Surface Mount Technology (SMT) devices that mount and attach from one side of the board. SMT mounting has a variety of forms. Many address mounting discrete components for hybrid circuits. Typical components are capacitors, resistors, inductors, LEDs, discrete transistors, etc. Sub-circuit or sub-assembly packages with combinations of these elements are also commonly packaged as SMT components. For example, filters and other RC circuits are often packaged as a single unit. Integrated circuit devices, with large numbers of devices, both passive devices and active transistors, are often mounted using SMT.

In attaching the components to the board surface, solder is the nearly universal attachment medium. This allows the attachment to also serve as an electrical interconnection. Electrical contacts on the component are soldered to conductor pads on the board. Electrical contacts on the component may be leadless, i.e. flat pre-tinned surface, or may be leads that extend from the component package. Leads on leaded chip carrier packages typically have distinct shapes, e.g. gull-wing, J-shaped, I-shaped.

The solder operation typically creates residue and debris. Residue is produced by solder fluxing agents, which are acidic, corrosive, and can contain ionic components that conduct electric signals. If not fully removed, these residues can lead to product reliability problems. Debris may comprise small particles of solder and/or other materials that form during the solder reflow steps, which also may be harmful to the finished device. Accordingly, SMT solder operations usually conclude with a cleaning step, wherein a fluid is circulated around the mounted devices. The flow of cleaning fluid also penetrates into the space between the component and the board, a space that often contains the harmful residue and debris. The space between the bottom of the component and the board or substrate is referred to below as the stand-off space, and the distance separating the substrate surface and the bottom of the component is referred to as the stand-off height. In SMT methods that use a soldermask on the board or substrate, the stand-off height is determined by the vertical distance between the top surface of the soldermask layer and the bottom surface of the component package. In leaded packages, the stand-off space is nominally controlled by the size and shape of the leads. In leadless chip carriers, and similar packages, the standoff is determined largely by the surface tension and collapse height of the solder during reflow.

As device density on the board increases to meet high packing requirements for small size and small profile packages, the stand-off space becomes more confined. The confined space is both more prone to trapping of residue and debris, and more inaccessible to the flow of cleaning fluid. Accordingly, where the stand-off space is very confined, the cleaning operation may be ineffective.

### Brief Statement of the Invention

The stand-off space can be enlarged significantly by selectively omitting, or selectively removing, the soldermask underneath the component package. The region on the substrate underneath the component package, where the component is soldered, is referred to here as the component footprint. It is typically square or rectangular. By selectively omitting the soldermask under the component, the stand-off height is increased by the thickness the omitted soldermask would have consumed. In state of the art SMT, the stand-off height is typically small, and the thickness of the soldermask is a significant fraction of the stand-off height.

### Brief Description of the Drawing

The invention may be better understood when considered in conjunction with the drawing in which:
Fig. 1 is a schematic diagram, partly in section, of a gull wing leaded component solder mounted on a circuit board and illustrating the prior art problem of trapped debris;
Fig. 2 is a schematic diagram in more detail identifying relevant dimensions described below;
Fig. 3 is a schematic view of a solder mounted leadless surface mount component similar to the view of Fig. 1, but illustrating the problem of trapped debris in another form of SMT;
Fig. 4 is a view similar to that of Fig. 1, but for a Ball Grid Array (BGA) or flip-chip SMT component;
Fig. 5 is a schematic view of the SMT solder mounted component of Fig. 1 showing the soldermask omitted from the region under the component;
Fig. 6 illustrates the effect on the relevant dimensions of Fig. 2 when the soldermask under the component is absent;
Fig. 7 is a plan view of the component of Fig. 5 showing section lines for Figs. 5 and 8;
Fig. 8 is the section view of the SMT component of Fig. 5 indicated in Fig. 7, showing flowing cleaning fluid in the stand-off space;
Fig. 9 is a view similar to that of Fig. 3 with the solder mask omitted from the region under the component;
Fig. 10 is a view similar to that of Fig. 4 with the solder mask omitted from the region under the component;
Fig. 11 is a plan view of a prior art soldermask also showing a leaded component in phantom;
Fig. 12 is a plan view of a soldermask fabricated according to the invention with the portion under the component absent;
Fig. 13 is a section view of Fig. 12 after application of solder paste;
Fig. 14 is a plan view, similar to Fig. 12, after application and reflow of solder paste;
Fig. 15 is an elevation of the SMT device after reflow of the solder bumps and placing the SMT;
Figs. 16 and 17 show modifications of the soldermask to provide enhanced access to the stand-off space.
Figs. 18 and 19 show modifications of the substrate shape to provide enhanced access to the stand-off space.

### Detailed Description of the Invention

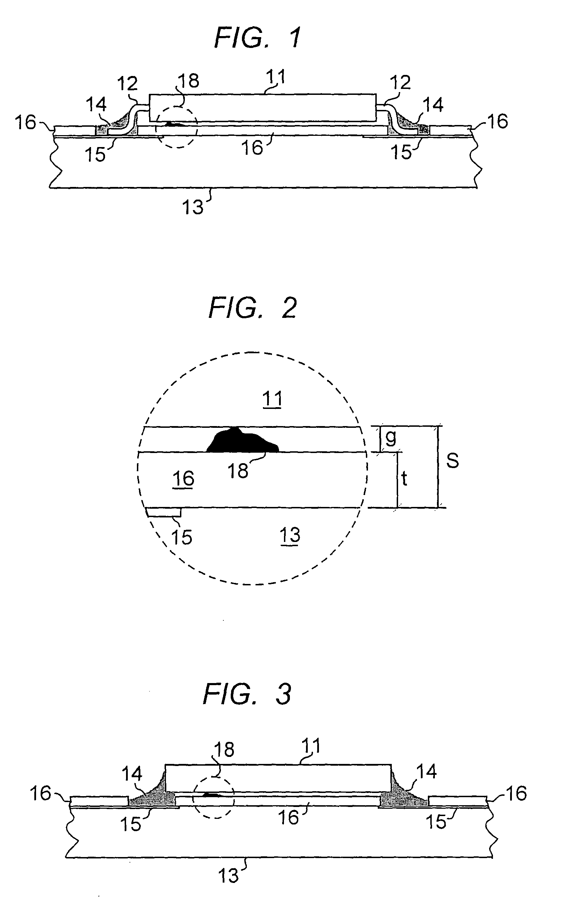

With reference to Fig. 1, a leaded component 11, with gull-wing leads 12 is shown surface mounted to substrate 13 by solder fillets 14. The structure relevant to the description of the invention is shown in section (the internal features of the component are not). The substrate 13, which may be a circuit board such as epoxy resin (e.g. FR4), is shown cut-away to indicate that the board shown in the figure is only a portion, typically a small portion, of a larger circuit board. Under the solder fillets are conductor pads 15. The conductor pads are integral with circuit runners that interconnect multiple components on the board. The conductor pads are typically copper, but may be aluminum or another metal with some form of top plated metal to insure wetting of the conductor pads by the applied solder.

Fig. 1 is representative of a common SMT method wherein a soldermask, here shown at 16, is used to selectively confine the location of solder on the substrate. Debris resulting from the soldering operation is shown at 18, trapped in the stand-off space between the soldermask layer 16, and the bottom of the component 11.

It will be understood that the elements in the figures are not necessarily to scale. For example, the thickness of the soldermask relative to other dimensions may be somewhat enhanced to illustrate the invention.

Fig. 2 shows the dashed circle portion of Fig. 1, and shows the stand-off space in more detail. The thickness of the soldermask layer is designated t in this figure. The standoff height S is nominally determined by the size and shape of leads 12. The leads either contact the surface of the substrate 13, or, if the component is very small may float slightly above the surface of the substrate. However, the nominal stand-off height as related to the solder sites is determined by the substrate surface, and has a maximum height of S. In actual practice however, the stand-off height underneath the component 11 is determined not by the surface of substrate 13, but by the surface of the soldermask layer 16. Accordingly, the actual stand-off height is g in Fig. 2. As mentioned earlier, this stand-off height grows smaller as device size shrinks. Fig. 2 shows debris 18 firmly trapped in the gap g.

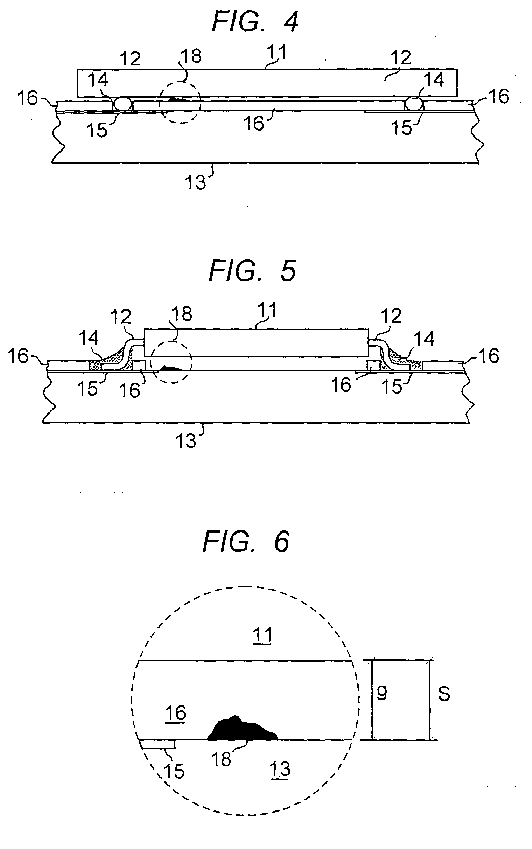

Figs. 1 and 2 illustrate in general the problem of debris or residue trapped or formed in the stand-off space. While the component shown here is a leaded package with gull-wing leads, the problem is broadly encountered in a wide variety of discrete component and integrated circuit packages. For illustration, Fig. 3 shows the problem in a leadless surface mount component. All elements are the same as in Fig. 1 except there are no leads 12. The stand-off under the surface mount component is determined largely by the solder surface-tension/collapse characteristics during solder reflow. The ends of the component are typically tinned (not shown) to promote wetting between the component and the conductor pads. Fig. 4 is another SMT package type, wherein solder bumps or BGA balls 24 are used for attaching the device 11. Typically the device 11 in BGA technology is an integrated circuit, and the number of balls, or interconnections, can be very large.

While it has been shown that the debris and residue problem exists over a variety of SMT package types, details below are described in connection with the gull-wing package of Fig. 1.

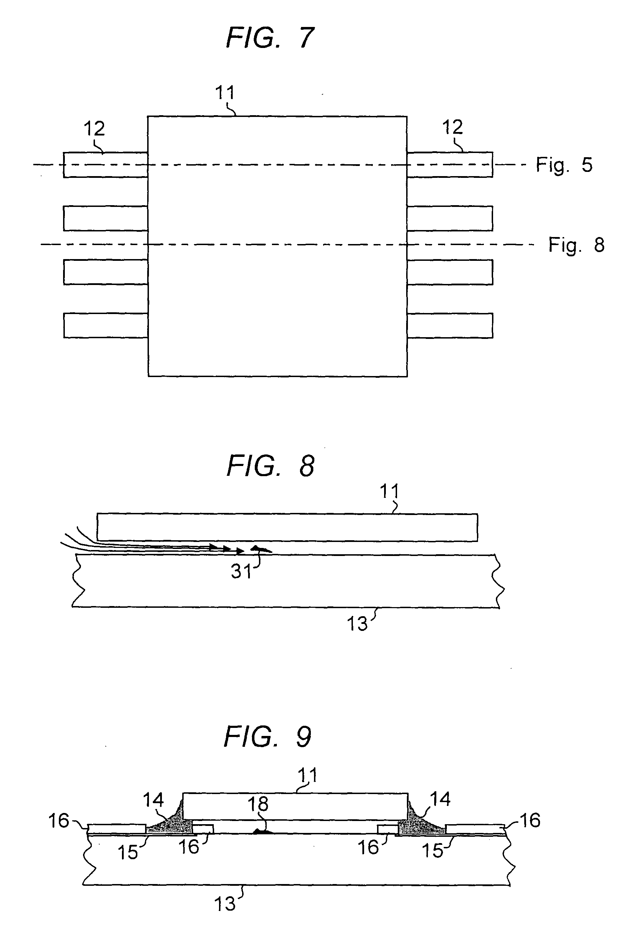

Fig. 5 shows the package of Fig. 1 with the soldermask omitted from the region approximately corresponding to the component footprint. Soldermask 16 still remains surrounding the solder sites as shown. The effect of omitting the solder mask from the component footprint is evident in Fig. 6, where the gap g between the bottom of component 11 and the substrate is equivalent to the maximum stand-off shown in Fig. 2, thus significantly enhancing access to the stand-off space by the cleaning fluid during the post-solder cleaning operation.

Fig. 5 shows a section through the leads 12 of the component 11, i.e. along line denoted "Fig. 5" in Fig. 7. The view between the leads, denoted by section line "Fig. 8" in Fig. 7, is shown in Fig. 8. Flow of cleaning fluid is represented by the arrows, and dislodged debris is shown at 31. It is seen that the flow of cleaning fluid is unhindered by a soldermask.

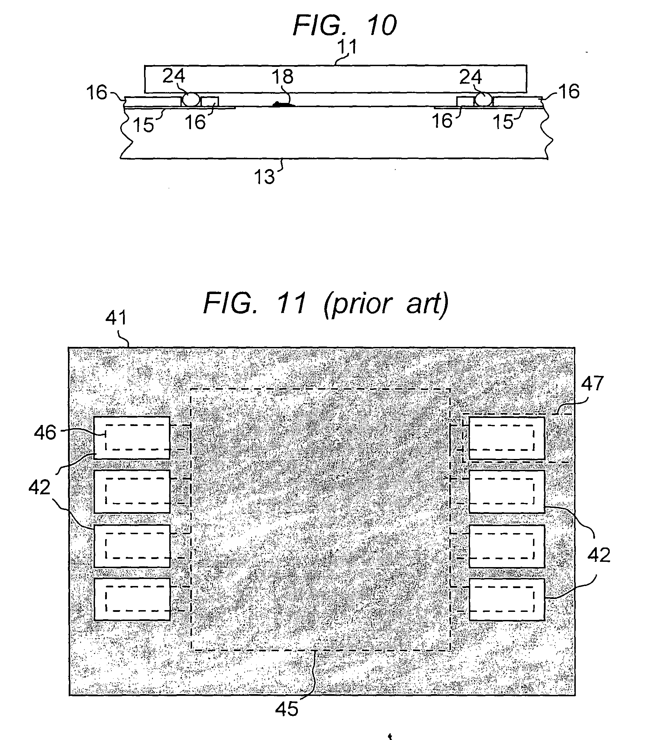

Fig. 9 shows the embodiment of Fig. 3, an SMT leadless chip carrier (LCC), with the soldermask omitted from the component footprint, and Fig. 10 shows the embodiment of Fig. 4 with the soldermask omitted from the footprint. In each case, the same effect as that described for Fig. 5 is evident.

In SMT technology, the soldermask layer is typically a polymer, for example, a polyimide, a polyacrylate, or suitable alternative. Preferably, it is a photoimageable polymer. The soldermask material is preferably blanket deposited on the substrate, and patterned using photolithography. A wide variety of photoresist type materials are known in the art, and these types of materials are easily applied and patterned by well known and well developed techniques. The layer is masked, exposed, and developed. Alternative methods, for example additive methods like screen printing, may also be used. Fig. 11 shows a plan view of a soldermask layer 41, patterned according to prior art teachings, to cover the substrate except in the solder sites 42. The component outline is shown in phantom at 45, with the component leads shown at 46. Also, a conductor pad 47 is shown in phantom. For clarity, only one conductor pad is shown, it being understood that a conductor pad underlies each solder site 42. The spacing between leads may be larger than that shown, to allow for some misalignment between the leads and the conductor pads. The conductor pads are typically made larger than the leads so that the base of the gull-wing resides entirely on the pads. In prior art SMT, the photomask for producing the soldermask appears much like Fig. 11, with a pattern of openings corresponding to the solder sites.

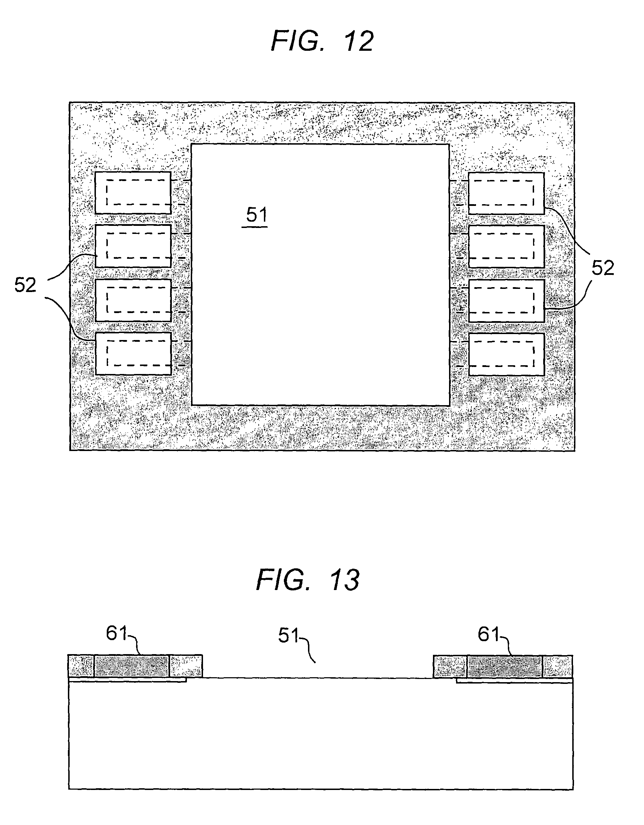

In contrast, a soldermask for implementing the invention is shown in Fig. 12, with opening 51, corresponding approximately to the component footprint. Solder site windows 52 are provided as shown.

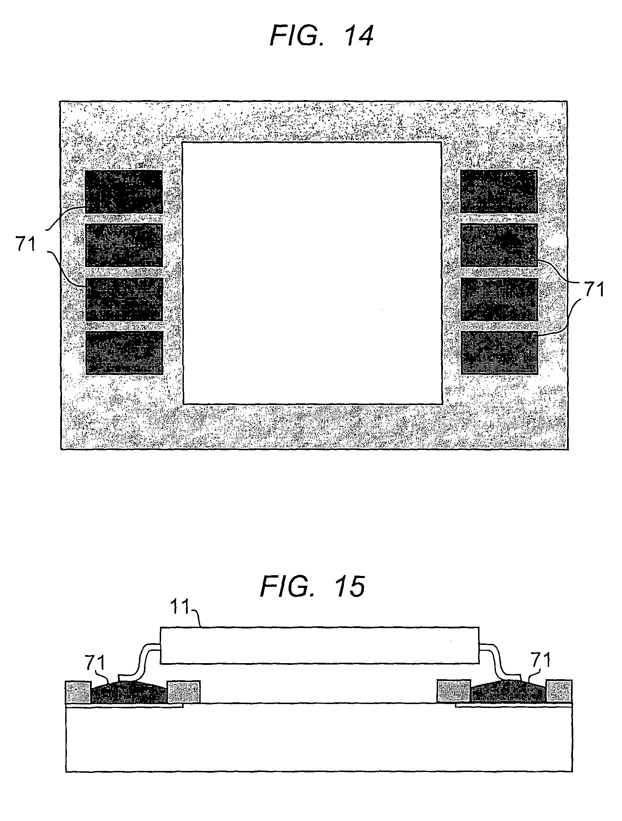

With the solder mask of Fig. 12 in place, the solder paste operation is performed in the usual manner except that paste is selectively applied to the solder site windows 52, and omitted in the region of the component footprint. This is illustrated in Fig. 13 where solder paste 61 is selectively deposited in the solder site windows. Selective application of solder paste may be easily implemented using a well known stencil method. The stencil is provided with openings for the solder sites but no opening in the component footprint region. The solder paste is then reflowed to produce solder bumps as shown at 71 in Fig. 14. Suitable solder bumps may also be produced by other methods. For example, solder may be evaporated through a shadow mask.

With the solder bumps formed, component 11 is placed, with leads aligned to the solder bumps 71, as shown in Fig. 15, and the solder reflowed to produce the assembly of Fig. 5. The cleaning operation, as described above, is then performed. The cleaning fluid may be any of many well known organic solvents or detergents.

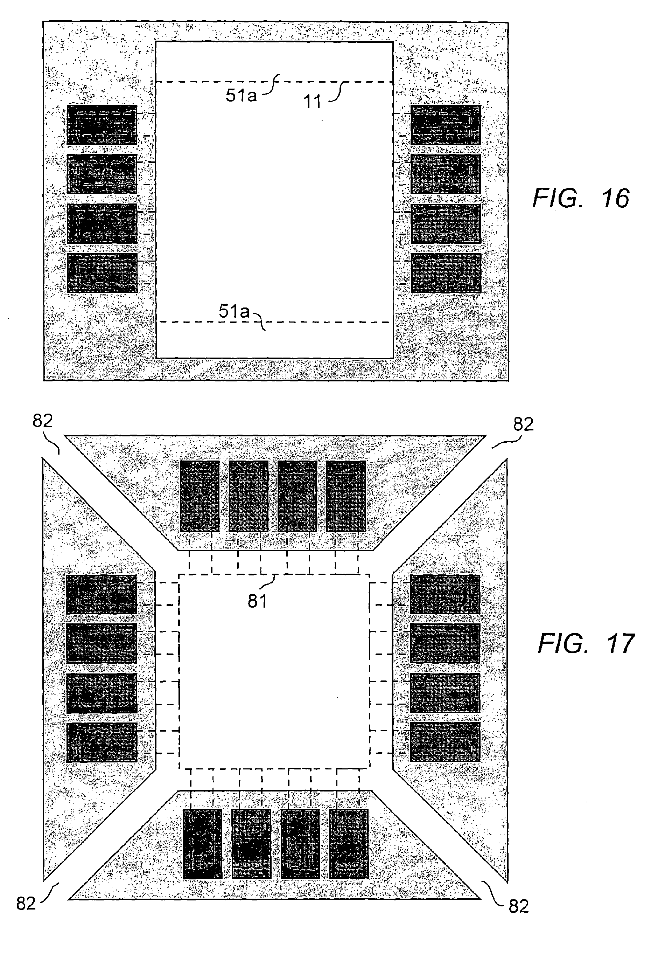

Several alternative expedients may be followed to further enhance access of the cleaning fluid to the region underneath the component. For example, recognizing that component 11 in Fig. 7 has leads on only two of the four sides, the open spaces on the ends of the soldermask may be extended to expand the void space. This is shown in Fig. 16 where extended void regions 51 a enlarge the component footprint to increase access to the region underneath the component. Fig. 17 shows an embodiment where the component, shown in phantom outline 81, has leads on all four sides. The opening in the soldermask underneath the component is made slightly larger than the component footprint and, additionally, one or more channels 82 are provided to increase accessibility of the cleaning fluid to the region underneath the component.

As mentioned there is a large variety of SMT devices than can be produced using the invention. There is also a variety of mounting substrates. PCBs are typically epoxy resin boards, e.g. FR4. They may be single or multilayer. Mounting substrates may also be ceramic or silicon.

While the expedient of omitting the soldermask in the region of the component footprint, as the soldermask is formed, is a simple implementation of the invention, other step sequences may achieve equivalent results. It is only important that the soldermask under the component be absent during the cleaning operation. Accordingly, the soldermask in the component footprint may be etched away in a separate step. This sequence may be useful if solder paste is applied with a squeegee, making it more difficult to confine the solder paste to just the solder sites. In that case, the conventional soldermask may be formed, the solder paste deposited and reflowed, then the component footprint region of the soldermask removed. There are several well known organic solvents available to selectively etch the soldermask.

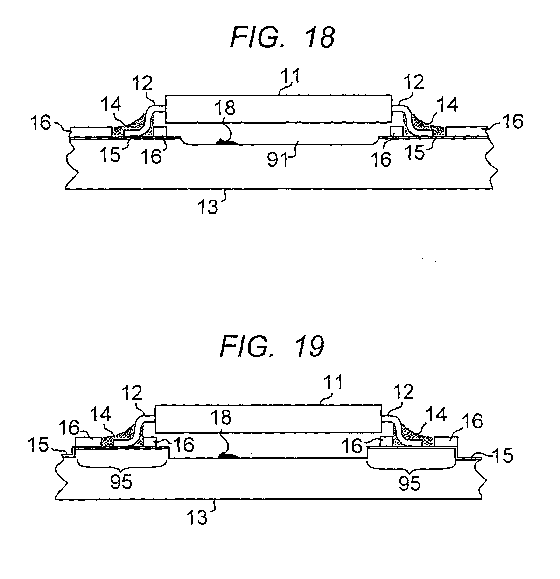

In the several embodiments of the invention already described the stand-off space is enhanced by removing a portion of the soldermask. An alternative to this is to remove portions of the substrate, or to shape the substrate, thereby increasing the stand-off height. Two embodiments for achieving this result are shown in Figs. 18 and 19. In Fig. 18, the area of the top surface of the substrate under the component footprint is selectively etched to form a depression 91 in the substrate. The soldermask can be present or omitted by choice. The stand-off height is increased by the depth of the etched depression. Alternatively, the substrate can be manufactured with pre-fabricated depressions. Forming a circuit board with depressions suitably located on the board is straightforward, especially since the circuit board is typically formed by a molding process. Fig. 19 represents embodiments where the substrate is molded with raised portions 95. These are located at the solder sites and function to raise the component from the board surface, thus achieving the objective of increasing the stand-off height.

Various additional modifications of this invention will occur to those skilled in the art. All deviations from the specific teachings of this specification that basically rely on the principles and their equivalents through which the art has been advanced are properly considered within the scope of the invention as described and claimed.

## Claims

1. Method for the manufacture of an electrical device comprising:
a. providing an interconnect substrate, the substrate having a top surface and a bottom surface, the top surface comprising a component footprint region, and a plurality of solder sites,
b. forming a soldermask layer on the top surface the soldermask layer having:
i. a plurality of openings surrounding the solder sites, and
ii. at least one opening surrounding at least a portion of the component footprint region, thereby leaving at least a portion of the component footprint region devoid of solder mask,
c. attaching an electrical component to the substrate by soldering parts of the component to the solder sites, the electrical component having a bottom side adjacent to and spaced from the substrate thereby leaving a stand-off space between the top surface of the substrate and the bottom side of the component,
d. cleaning the substrate by exposing the substrate to a cleaning fluid, the cleaning step including cleaning the stand-off space by exposing the stand-off space to the cleaning fluid.

2. The method of claim 1 wherein solder paste is selectively applied to the solder sites.

3. The method of claim 1 wherein the component is a leadless device.

4. The method of claim 1 wherein the component is a leaded device.

5. The method of claim 1 wherein the size of the opening in b.ii exceeds the size of the component footprint region.

6. The method of claim 1 wherein the solder mask is formed by depositing a blanket layer of a photoimageable polymer on the substrate, exposing regions of the blanket layer to light, and removing the exposed regions, wherein the exposed regions correspond to b.i and b.ii.

7. The method of claim 2 wherein the solder paste is selectively applied using a stencil method.

8. The method of claim 1 wherein components are mounted on the bottom side of the substrate.

9. A SMT device comprising:
a. an interconnect substrate, the substrate having a top surface and a bottom surface, the top surface comprising a component footprint region, and a plurality of solder sites,
b. a soldermask layer on the top surface the soldermask layer having:
i. a plurality of openings surrounding the solder sites, and
ii. at least one opening surrounding at least a portion of the component footprint region, thereby leaving at least a portion of the component footprint region devoid of solder mask,
c. an electrical component soldered to the solder sites, the electrical component having a bottom side adjacent to and spaced from the substrate thereby leaving a stand-off space between the top surface of the substrate and the bottom side of the component.

10. The SMT device of claim 9 wherein the area of the opening in b.ii exceeds the area of the component footprint region.

11. The SMT device of claim 9 wherein the device is a leadless chip carrier.

12. The SMT device of claim 9 wherein the device is a leaded device.

13. The SMT device of claim 9 wherein the soldermask layer comprises a photoimageable polymer.

14. The SMT device of claim 9 further comprising a depression in the substrate in the component footprint region.

15. The SMT device of claim 9 wherein the substrate is a printed circuit board.

16. The SMT device of claim 15 wherein the substrate is a polymer.

17. The SMT of claim 9 wherein the substrate is ceramic.

18. The SMT of claim 9 further comprising a raised portion of substrate at the solder sites.

19. The device of claim 9 further comprising components mounted on the bottom side of the substrate.
